(19) Europäisches Patentamt / European Patent Office / Office européen des brevets

(11) **EP 3 244 270 B1**

(12) **EUROPÄISCHE PATENTSCHRIFT**

(45) Veröffentlichungstag und Bekanntmachung des Hinweises auf die Patenterteilung:
**19.09.2018** **Patentblatt 2018/38**

(21) Anmeldenummer: **16169294.2**

(22) Anmeldetag: **12.05.2016**

(51) Int Cl.:
*G05B 5/01* (2006.01)    *G05B 19/12* (2006.01)
*G05B 19/4063* (2006.01)    *G05B 19/408* (2006.01)
*G05B 19/4099* (2006.01)    *H03L 7/02* (2006.01)

(54) **REGELEINRICHTUNG MIT LERNFÄHIGER FEHLERKOMPENSATION**

CONTROL DEVICE WITH ADAPTIVE ERROR COMPENSATION

DISPOSITIF DE REGLAGE A COMPENSATION D'ERREUR ADAPTATIVE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.11.2017** **Patentblatt 2017/46**

(73) Patentinhaber: **Siemens Aktiengesellschaft**
**80333 München (DE)**

(72) Erfinder:
• **Haschka, Markus Stephan**
**90419 Nürnberg (DE)**
• **Rost, Philipp**
**90425 Nürnberg (DE)**
• **Schäfers, Elmar**
**90763 Fürth (DE)**
• **Schür, Torsten**
**91058 Erlangen (DE)**
• **Seelinger, Björn**
**91315 Höchstadt (DE)**

(56) Entgegenhaltungen:
**EP-A1- 2 988 181**

## Beschreibung

Die vorliegende Erfindung geht aus von einer Regeleinrichtung zum Regeln einer Regelstrecke,

- wobei die Regeleinrichtung einen vorderen Knotenpunkt, einen hinteren Knotenpunkt, einen zwischen dem vorderen und dem hinteren Knotenpunkt angeordneten äußeren Abgreifpunkt, einen Regler und einen Kompensationskreis aufweist,
- wobei der Kompensationskreis einen inneren Knotenpunkt, ein Frequenzfilter, einen vorderen Pufferspeicher und einen hinteren Pufferspeicher aufweist,
- wobei der vordere Knotenpunkt einen ausgangsseitig der Regelstrecke mittels einer Messeinrichtung erfassten Istwert und einen korrespondierenden Sollwert entgegennimmt und durch Bildung von deren Differenz eine Regeldifferenz ermittelt,
- wobei der hintere Knotenpunkt die Regeldifferenz und ein Kompensationssignal entgegennimmt und dem Regler ein durch Addieren von Regeldifferenz und Kompensationssignal gebildetes äußeres Summensignal zuführt,
- wobei der Regler anhand des äußeren Summensignals ein Stellsignal für die Regelstrecke ermittelt und an die Regelstrecke ausgibt,
- wobei der innere Knotenpunkt durch Addieren der an dem äußeren Abgreifpunkt abgegriffenen und mit einem ersten Wichtungsfaktor gewichteten Regeldifferenz und eines mit einem zweiten Wichtungsfaktor gewichteten Rückkopplungssignals ein inneres Summensignal bildet und dem Frequenzfilter zuführt,
- wobei das Frequenzfilter eine Frequenzfilterung durchführt und das gefilterte Signal dem vorderen Pufferspeicher zuführt,
- wobei der vordere Pufferspeicher das gefilterte Signal um eine erste Laufzeitverzögerung verzögert und das entsprechend verzögerte Signal als Ausgangssignal ausgibt,
- wobei der hintere Pufferspeicher das Kompensationssignal um eine zweite Laufzeitverzögerung verzögert und das entsprechend verzögerte Signal als Rückkopplungssignal ausgibt,
- wobei in einem Normalbetrieb der Regeleinrichtung das Ausgangssignal des vorderen Pufferspeichers als Kompensationssignal herangezogen wird.

Die vorliegende Erfindung geht weiterhin aus von einem Softwaremodul, das Maschinencode umfasst, dessen Abarbeitung durch eine softwareprogrammierbare Regeleinrichtung bewirkt, dass die Regeleinrichtung entsprechend ausgebildet ist.

Derartige Regeleinrichtungen und die zugehörigen Softwaremodule sind allgemein bekannt. Die Regeleinrichtung wird oftmals auch als lernfähige Regelung bezeichnet. Eine derartige Regeleinrichtung ist beispielsweise aus der EP 2 988 181 A1 bekannt. Bei der bekannten Regeleinrichtung erfolgt die Parametrierung des Kompensationskreises durch einen Benutzer.

Bei manchen geregelten technischen Größen - insbesondere Lagewerten bei Rundachsen - treten periodische Störungen auf. Derartige Störungen können beispielsweise durch Trägheits- oder Bearbeitungskräfte bei Werkzeugmaschinen oder anderen Produktionsmaschinen auftreten. Eine Unterdrückung derartiger Störungen durch eine lernfähige Regelung mit Fehlerkompensation verbessert die Qualität der Regelung erheblich, manchmal um mehr als eine Größenordnung.

Die Parametrierung einer lernfähigen Regelung ist insbesondere bei komplexen zu regelnden Anlagen oftmals schwierig. Insbesondere dann, wenn sich die Übertragungsfunktion des geschlossenen Regelkreises nicht zuverlässig messen lässt, ist eine für die praxistaugliche Strategie zur Bestimmung der Parameter der lernfähigen Regelung nicht bekannt.

Die Aufgabe der vorliegenden Erfindung besteht darin, eine Möglichkeit zu schaffen, mittels derer eine stabile Parametrierung der lernfähigen Regelung unabhängig davon möglich ist, ob die Übertragungsfunktion des geschlossenen Regelkreises gemessen werden kann oder nicht.

Die Aufgabe wird durch eine Regeleinrichtung mit den Merkmalen des Anspruchs 1 gelöst. Vorteilhafte Ausgestaltungen der Regeleinrichtung sind Gegenstand der abhängigen Ansprüche 2 bis 9.

Erfindungsgemäß wird eine Regeleinrichtung der eingangs genannten Art dadurch ausgestaltet, dass die Regeleinrichtung eine Einstelleinrichtung aufweist und dass die Einstelleinrichtung in einem Einstellbetrieb der Regeleinrichtung automatisch

- die Verwendung des Ausgangssignals des vorderen Pufferspeichers als Kompensationssignal unterdrückt,
- dem hinteren Pufferspeicher und dem hinteren Knotenpunkt stattdessen als Kompensationssignal ein Anregungssignal zuführt,
- ein durch das Anregungssignal hervorgerufenes Ergebnissignal erfasst, wobei das Ergebnissignal die Regeldifferenz, das innere Summensignal, das Ausgangssignal des Frequenzfilters oder das Ausgangssignal des vorderen Pufferspeichers ist, und

- basierend auf einer Auswertung des Anregungssignals und des Ergebnissignals zumindest mindestens einen Parameter des Frequenzfilters und die zweite Laufzeitverzögerung einstellt.

Die entsprechenden Einstellungen werden im nachfolgenden Normalbetrieb der Regeleinrichtung als entsprechende Einstellungen des Frequenzfilters und des hinteren Pufferspeichers verwendet.

Als Parameter des Frequenzfilters kommt insbesondere dessen Grenzfrequenz in Frage. Alternativ oder zusätzlich kann im Einzelfall aber auch die Ordnung des Frequenzfilters parametriert werden.

Es ist möglich, dass die Einstelleinrichtung im Rahmen der Auswertung des Anregungssignals und des Ergebnissignals eine Übertragungsfunktion des geschlossenen Regelkreises ermittelt und die Einstelleinrichtung den mindestens einen Parameter des Frequenzfilters und die zweite Laufzeitverzögerung basierend auf einer Auswertung der Übertragungsfunktion des geschlossenen Regelkreises einstellt. Diese Vorgehensweise ist insbesondere dann von Vorteil, wenn die Übertragungsfunktion des geschlossenen Regelkreises mit hinreichender Genauigkeit ermittelt werden kann.

Im Falle der Verwertung der Übertragungsfunktion ist vorzugsweise vorgesehen,

- dass die Einstelleinrichtung eine Mehrzahl von Vektoren ermittelt, die als Vektorkomponenten jeweils zumindest den mindestens einen Parameter des Frequenzfilters und die zweite Laufzeitverzögerung enthalten,
- dass die Einstelleinrichtung unter Verwertung der Übertragungsfunktion für die Mehrzahl von Vektoren jeweils ein Verhältnis des Ausgangssignals des vorderen Pufferspeicher zum Anregungssignal als Funktion der Frequenz ermittelt,
- dass die Einstelleinrichtung den mindestens einen Parameter des Frequenzfilters und die zweite Laufzeitverzögerung gemäß demjenigen Vektor einstellt, der gemäß einem vorbestimmten Optimierungskriterium als optimal bewertet wird,
- dass das Optimierungskriterium als einzuhaltende Randbedingung enthält, dass das Verhältnis des Ausgangssignals des vorderen Pufferspeichers zum Anregungssignal als Funktion der Frequenz unterhalb einer vorbestimmten Schwelle bleibt, die ihrerseits kleiner als 1 ist, und
- dass weiterhin der Vektor umso besser bewertet wird, je höher die Grenzfrequenz des Frequenzfilters ist.

Auf diese Weise kann automatisiert eine optimale Parametrierung der lernfähigen Regelung erreicht werden.

Es ist möglich, dass die Einstelleinrichtung zusätzlich auch andere Werte bestimmt. Insbesondere ist es möglich, dass die Einstelleinrichtung zusätzlich den ersten Wichtungsfaktor und den zweiten Wichtungsfaktor bestimmt. Alternativ ist es jedoch ebenso möglich, dass die Einstelleinrichtung den ersten Wichtungsfaktor und den zweiten Wichtungsfaktor auf vorbestimmte Werte festsetzt, also auf Werte, die nicht von der ermittelten Übertragungsfunktion abhängen.

Ihre volle Stärke zeigt die vorliegende Erfindung jedoch in dem Fall, dass die Übertragungsfunktion nicht oder nur mit unzureichender Genauigkeit ermittelt werden kann. Denn auch in diesem Fall ist es möglich, dass die Einstelleinrichtung basierend auf der Auswertung des Anregungssignals und des Ergebnissignals eine niedrigste Tilgerfrequenz des geschlossenen Regelkreises ermittelt. Die Einstelleinrichtung kann in diesem Fall insbesondere den mindestens einen Parameter des Frequenzfilters derart bestimmen, dass die Grenzfrequenz des Frequenzfilters einem vorbestimmten Prozentsatz der Tilgerfrequenz entspricht.

Zusätzlich ist es möglich, dass in diesem Fall (wenn also die Tilgerfrequenz zur Bestimmung der Grenzfrequenz des Frequenzfilters herangezogen wird) die Einstelleinrichtung bei einer Hilfsfrequenz, die kleiner als die anhand der Tilgerfrequenz ermittelte Grenzfrequenz des Frequenzfilters ist, eine Regelkreislaufzeit für die Hilfsfrequenz ermittelt, wobei die Regelkreislaufzeit diejenige Zeit ist, die vergeht, bis ein dem vorderen Knotenpunkt zugeführtes Signal eine Änderung des Istwerts bewirkt, und die zweite Laufzeitverzögerung auf die Regelkreislaufzeit einstellt.

Im Falle der Verwendung der Tilgerfrequenz zur Bestimmung der Grenzfrequenz des Frequenzfilters setzt weiterhin vorzugsweise die Einstelleinrichtung den ersten Wichtungsfaktor und den zweiten Wichtungsfaktor auf vorbestimmte Werte fest.

Es ist sogar möglich, dass die Einstelleinrichtung vor oder nach dem Zuführen des Anregungssignals zum hinteren Pufferspeicher und zum hinteren Knotenpunkt

- die Verwendung des Ausgangssignals des vorderen Pufferspeichers als Kompensationssignal unterdrückt,
- dem hinteren Pufferspeicher und dem hinteren Knotenpunkt als Kompensationssignal mindestens ein weiteres Anregungssignal zuführt,
- das dadurch hervorgerufene Ergebnissignal erfasst, wobei das nunmehr hervorgerufene Ergebnissignal die nunmehr hervorgerufene Regeldifferenz, das nunmehr hervorgerufene innere Summensignal, das nunmehr hervorgerufene Ausgangssignal des Frequenzfilters oder das nunmehr hervorgerufene Ausgangssignal des vorderen Pufferspeichers ist, und

- basierend auf einer Auswertung des Anregungssignals und des Ergebnissignals einerseits und des weiteren Anregungssignals und des dadurch hervorgerufenen Ergebnissignals andererseits entscheidet, ob sie die Einstellung des mindestens einen Parameters des Frequenzfilters und der zweiten Laufzeitverzögerung gemäß der einen oder der anderen Vorgehensweise vornimmt.

Die Regeleinrichtung ist dadurch in der Lage, sich automatisch

- in dem Fall, dass sie die Übertragungsfunktion zuverlässig ermitteln kann, optimal zu parametrieren und dennoch
- in dem Fall, dass sie die Übertragungsfunktion nicht oder nur unzuverlässig ermitteln kann, derart zu parametrieren, dass die lernfähige Regelung zwar nicht optimal ist, aber stabil bleibt.

Der Kompensationskreis wirkt innerhalb des geschlossenen Regelkreises. Er kann daher im Einzelfall instabil werden. Die anfängliche Parametrierung des Kompensationskreises wird zwar derart gewählt, dass die lernfähige Regelung (einschließlich Kompensationskreis) stabil ist. Bei komplexen Maschinen kann es jedoch geschehen, dass die Übertragungsfunktion des geschlossenen Regelkreises sich im Laufe der Zeit ändert. Genau in diesem Fall kann die Instabilität auftreten. Um im Falle einer derartigen Instabilität eine Beschädigung der gesteuerten Einrichtung zu vermeiden, ist vorzugsweise vorgesehen,

- dass die Regeleinrichtung eine Überwachungseinrichtung aufweist,
- dass die Überwachungseinrichtung im Normalbetrieb der Regeleinrichtung automatisch den zeitlichen Verlauf des Kompensationssignals überwacht und
- dass die Überwachungseinrichtung die Verwendung des Ausgangssignals des vorderen Pufferspeichers als Kompensationssignal unterdrückt und/oder den mindestens einen Parameter des Frequenzfilters und/oder die zweite Laufzeitverzögerung auf andere Werte einstellt, sobald die Überwachung des zeitlichen Verlaufs des Kompensationssignals eine Instabilität des Kompensationskreises anzeigt.

In vielen Fällen ist die Regeleinrichtung als softwareprogrammierbare Regeleinrichtung ausgebildet und mit einem Softwaremodul programmiert, so dass sie aufgrund der Programmierung mit dem Softwaremodul erfindungsgemäß ausgebildet ist.

Eine besonders bevorzugte Verwendung der Regeleinrichtung besteht darin, sie zur Steuerung einer Achse einer Druckmaschine zu verwenden.

Die Aufgabe wird weiterhin durch ein Softwaremodul mit den Merkmalen des Anspruchs 11 gelöst. Erfindungsgemäß bewirkt die Abarbeitung des Maschinencodes des Softwaremoduls durch eine softwareprogrammierbare Regeleinrichtung, dass die Regeleinrichtung erfindungsgemäß ausgebildet ist. Das Softwaremodul kann insbesondere auf einem Datenträger in maschinenlesbarer Form gespeichert sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:

FIG 1        eine Regeleinrichtung zum Regeln einer Regelstrecke,
FIG 2        ein Zeitdiagramm einer Störung,
FIG 3        die Regeleinrichtung von FIG 1 bei geöffnetem Kompensationskreis,
FIG 4 und 5  Ablaufdiagramme,
FIG 6        Frequenzgänge,
FIG 7 und 8  Ablaufdiagramme,
FIG 9        ein Zeitdiagramm eines Kompensationssignals,
FIG 10       ein Ablaufdiagramm und
FIG 11       eine Regeleinrichtung zum Regeln einer Regelstrecke.

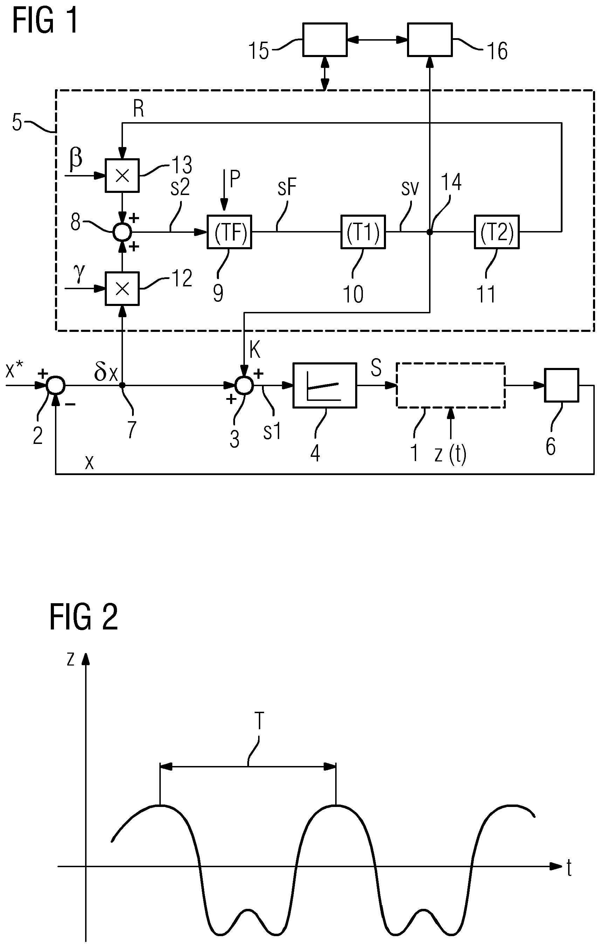

Gemäß FIG 1 weist eine Regeleinrichtung zum Regeln einer Regelstrecke 1 einen vorderen Knotenpunkt 2, einen hinteren Knotenpunkt 3, einen Regler 4 und einen Kompensationskreis 5 auf. Die Regeleinrichtung kann insbesondere zur Steuerung einer Achse einer Druckmaschine - insbesondere einer sogenannten Rundachse - verwendet werden. Sie kann aber auch anderweitig verwendet werden, sei es für die Steuerung einer Rundachse, sei es für die Steuerung einer Linearachse, sei es anderweitig.

In einem Normalbetrieb der Regeleinrichtung nimmt der vordere Knotenpunkt 2 einen Istwert x und einen korrespondierenden Sollwert x* entgegen. Der Istwert x wird ausgangsseitig der Regelstrecke 1 mittels einer Messeinrichtung 6 messtechnisch erfasst. Der vordere Knotenpunkt 2 ermittelt durch Bildung der Differenz von Sollwert x* und Istwert x eine Regeldifferenz δx. Der hintere Knotenpunkt 3 nimmt die Regeldifferenz δx und ein Kompensationssignal K entgegen. Der hintere Knotenpunkt 3 addiert die Regeldifferenz δx und das Kompensationssignal K und bildet dadurch ein Summensignal s1, nachfolgend als äußeres Summensignal s1 bezeichnet. Der hintere Knotenpunkt 3 führt das äußere Summensignal s1 dem Regler 4 zu. Der Regler 4 ermittelt anhand des ihm zugeführten äußeren Summensignals s1 ein Stellsignal S für die Regelstrecke 1. Der Regler 4 gibt das Stellsignal S an die Regelstrecke 1 aus. Der Regler 4 kann beispielsweise als PI-Regler ausgebildet sein. Er kann jedoch auch eine andere Reglercharakteristik aufweisen.

Der erfasste Istwert x ist mit einer Störung z beaufschlagt. Die Störung z ist gemäß der Darstellung in FIG 2 eine periodische Funktion der Zeit t. Sie weist also eine Periodendauer T auf. Der Kompensation der Störung z dienen der Kompensationskreis 5 und das von dem Kompensationskreis 5 ermittelte Kompensationssignal K.

Um das Kompensationssignal K ermitteln zu können, weist die Regeleinrichtung einen äußeren Abgreifpunkt 7 auf, der zwischen dem vorderen und dem hinteren Knotenpunkt 2, 3 angeordnet ist. An dem äußeren Abgreifpunkt 7 wird die Regeldifferenz δx abgegriffen und dem Kompensationskreis 5 zugeführt. Der Kompensationskreis 5 ermittelt das Kompensationssignal K und führt es dem hinteren Knotenpunkt 3 zu.

Der Kompensationskreis 5 weist einen inneren Knotenpunkt 8, ein Frequenzfilter 9, einen vorderen Pufferspeicher 10 und einen hinteren Pufferspeicher 11 auf. Dem inneren Knotenpunkt 8 sind zwei Multiplizierer 12, 13 vorgeordnet. Dem Multiplizierer 12 wird die Regeldifferenz δx zugeführt, dem Multiplizierer 13 ein Rückkopplungssignal R. Die Multiplizierer 12, 13 multiplizieren die ihnen zugeführten Signale δx, R mit einem jeweiligen Wichtungsfaktor γ, β und führen die Produkte dem inneren Knotenpunkt 8 zu. Der innere Knotenpunkt 8 nimmt die Produkte entgegen. Der innere Knotenpunkt 8 addiert die mit dem Wichtungsfaktor γ gewichtete Regeldifferenz δx und das mit dem Wichtungsfaktor β gewichtete Rückkopplungssignal R und bildet so ein weiteres Summensignal s2, nachfolgend als inneres Summensignal s2 bezeichnet. Das innere Summensignal s2 führt der innere Knotenpunkt 8 dem Frequenzfilter 9 zu.

Das Frequenzfilter 9 führt eine Frequenzfilterung durch. Das Frequenzfilter 9 kann zu diesem Zweck beispielsweise als nichtrekursives digitales Filter ausgebildet sein, insbesondere als Tiefpassfilter. Eine Filterordnung des Frequenzfilters 9 kann durch Einstellen entsprechender Parameter P einstellbar sein. Gleiches gilt für eine Grenzfrequenz fG des Frequenzfilters 9. Das Frequenzfilter 9 führt das entsprechend gefilterte Signal sf - nachfolgend auch als Filtersignal sf bezeichnet - dem vorderen Pufferspeicher 10 zu.

Der vordere Pufferspeicher 10 verzögert das Filtersignal sf des Frequenzfilters 9 um eine erste Laufzeitverzögerung T1 und gibt es sodann als Ausgangssignal sv aus. Das Ausgangssignal sv führt der vordere Pufferspeicher 10 im Normalbetrieb dem hinteren Pufferspeicher 11 zu. In analoger Weise verzögert der hintere Pufferspeicher 11 das Ausgangssignal sv um eine zweite Laufzeitverzögerung T2. Das entsprechend verzögerte Signal gibt der hintere Pufferspeicher 11 als Rückkopplungssignal R aus.

Zwischen dem vorderen Pufferspeicher 10 und dem hinteren Pufferspeicher 11 ist ein innerer Abgreifpunkt 14 angeordnet. An dem inneren Abgreifpunkt 14 wird das Kompensationssignal K abgegriffen und dem hinteren Knotenpunkt 3 zugeführt. Es ist im Normalbetrieb mit dem Ausgangssignal sv identisch. Das Ausgangssignal sv des vorderen Pufferspeichers 10 wird also im Normalbetrieb der Regeleinrichtung als Kompensationssignal K herangezogen.

Das Frequenzfilter 9 weist, wie bereits erwähnt, eine Filterordnung auf. Die Filterordnung korrespondiert mit einer Verzögerungszeit TF. In der Regel sind das Frequenzfilter 9 und die beiden Pufferspeicher 10, 11 derart ausgelegt, dass die Beziehung

$$TF + T1 + T2 = n \cdot T \qquad (1)$$

gilt. n ist eine ganze Zahl. In der Regel ist die Zahl n so klein wie möglich. Oftmals weist die Zahl n den Wert 1 oder den Wert 2 auf.

Die Regelstrecke 1 weist in Verbindung mit der normalen Regelung (d.h. ohne Kompensationskreis 5) eine Regelkreislaufzeit TL auf. Die Regelkreislaufzeit TL ist diejenige Zeit, die vergeht, bis ein dem vorderen Knotenpunkt 2 zugeführtes Signal eine Änderung des Istwerts x bewirkt. Der hintere Pufferspeicher 11 sollte derart ausgelegt sein, dass die Beziehung

$$T2 = TL \qquad (2)$$

gilt. Somit ist die Summe der Verzögerungszeiten TF, T1 von Frequenzfilter 9 und vorderem Pufferspeicher 10 ein ganzzahliges Vielfaches der Periodendauer T der Störung z abzüglich der Regelkreislaufzeit TL.

Die Regeleinrichtung weist weiterhin eine Einstelleinrichtung 15 auf. Die Einstelleinrichtung 15 wirkt in einem Einstellbetrieb der Regeleinrichtung. Die Funktion der Einstelleinrichtung 15 ist hierbei automatisch.

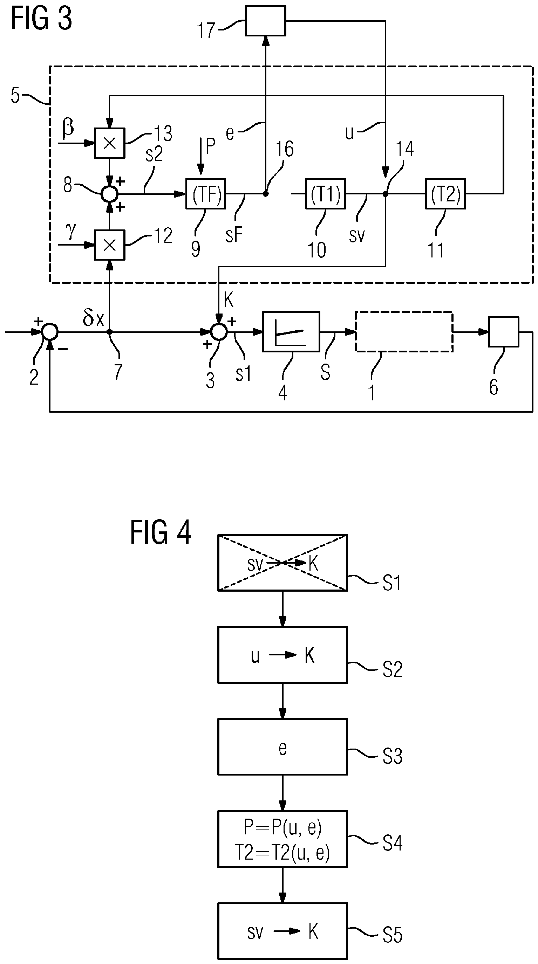

Im Einstellbetrieb trennt die Einstelleinrichtung 15 - siehe die FIG 3 und 4 - in einem Schritt S1 die Verbindung des Frequenzfilters 9 mit dem hinteren Pufferspeicher 11 auf. Das Auftrennen kann alternativ vor dem vorderen Pufferspeicher 10, im vorderen Pufferspeicher 10 oder hinter dem vorderen Pufferspeicher 10 erfolgen. Durch das Auftrennen der Verbindung wird insbesondere die Verwendung des Ausgangssignals sv des vorderen Pufferspeichers 10 als Kompensationssignal K unterdrückt. Stattdessen führt die Einstelleinrichtung 15 in einem Schritt S2 dem hinteren Pufferspeicher 11 und dem hinteren Knotenpunkt 3 als Kompensationssignal K ein Anregungssignal u zu. Weiterhin erfasst die Einstelleinrichtung 15 in einem Schritt S3 ein Ergebnissignal e, das durch das Anregungssignal u hervorgerufen wird. Bei dem Ergebnissignal e kann es sich entsprechend der Darstellung in FIG 3 um das Filtersignal sf handeln, also das Ausgangssignal des Frequenzfilters 9. Alternativ kann es sich bei dem Ergebnissignal e um die Regeldifferenz $\delta x$, das innere Summensignal s2 oder das Ausgangssignal sv des vorderen Pufferspeichers 10 handeln. Die letztmögliche Ausgestaltung ist nur dann möglich, wenn das Auftrennen der Verbindung des Frequenzfilters 9 mit dem hinteren Pufferspeicher 11 hinter dem vorderen Pufferspeicher 10 erfolgt.

In einem Schritt S4 stellt die Einstelleinrichtung 15 sodann mindestens einen Parameter P des Frequenzfilters 9 und die zweite Laufzeitverzögerung T2 ein. Die Einstellung des mindestens einen Parameters P und der zweiten Laufzeitverzögerung T2 basiert auf einer Auswertung des Anregungssignals u und des Ergebnissignals e. Danach stellt die Einstelleinrichtung 15 in einem Schritt S5 die Verbindung des Frequenzfilters 9 mit dem hinteren Pufferspeicher 11 wieder her. Das Ausgangssignal sv des vorderen Pufferspeichers 10 wird also wieder als Kompensationssignal K verwendet. Mit dem Wiederaufschalten des Kompensationssignals K ist der Ermittlungsbetrieb beendet.

Mit Ausnahme des Auftrennens der Verbindung des Frequenzfilters 9 mit dem hinteren Pufferspeicher 11 und der damit verbundenen, obenstehend erläuterten Unterschiede im Normalbetrieb bleibt der Betrieb der Regeleinrichtung im Einstellbetrieb unverändert.

Die Vorgehensweise der vorliegenden Erfindung basiert darauf, dass im Einstellbetrieb für die Regeldifferenz $\delta x$, das innere Summensignal s1, das Filtersignal sf und das Ausgangssignal sv des vorderen Pufferspeichers 10 die Beziehungen

$$\delta x(s) = G(s) \cdot u(s) \qquad\qquad (3)$$

$$s2(s) = \left(\gamma G(s) + \beta e^{-sT2}\right) \cdot u(s) \qquad\qquad (4)$$

$$sF(s) = H(s) \cdot \left(\gamma G(s) + \beta e^{-sT2}\right) \cdot u(s) \qquad\qquad (5)$$

$$sv(s) = e^{-sT1} \cdot H(s) \cdot \left(\gamma G(s) + \beta e^{-sT2}\right) \cdot u(s) \qquad\qquad (6)$$

gelten. In den Gleichungen (3) bis (6) sind s der Laplace-Operator, G die Übertragungsfunktion des geschlossenen Regelkreises und H die Filterfunktion des Frequenzfilters 9. In den Gleichungen (3) bis (6) ist im wesentlichen nur die Übertragungsfunktion G unbekannt. Die Übertragungsfunktion G kann daher anhand einer der Gleichungen (3) bis (6) bestimmt werden.

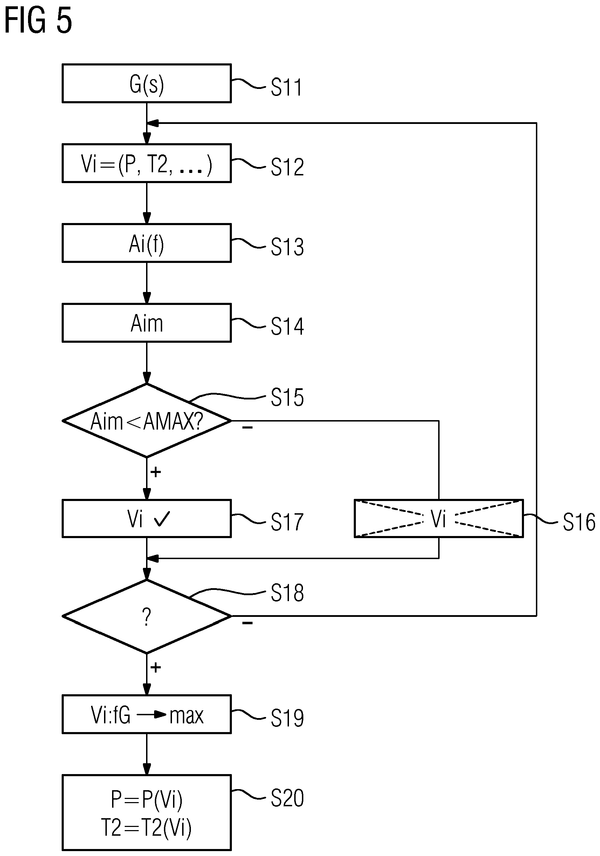

In einer möglichen Implementierung des Schrittes S4 von FIG 4 ist es daher gemäß FIG 5 - siehe dort für den Fall der Verwendung von Gleichung (3) - möglich, dass die Einstelleinrichtung 15 im Rahmen der Auswertung des Anregungssignals u und des Ergebnissignals e in einem Schritt S11 die Übertragungsfunktion G(s) des geschlossenen Regelkreises ermittelt. In diesem Fall stellt die Einstelleinrichtung 15 den mindestens einen Parameter P des Frequenzfilters 9 und die zweite Laufzeitverzögerung T2 basierend auf einer Auswertung der Übertragungsfunktion G ein. Insbesondere kann die Einstelleinrichtung 15 in diesem Fall in einem Schritt S12 einen Vektor Vi (i = 1, 2, 3, ...) ermitteln. Der Vektor Vi enthält als Vektorkomponenten einen Satz einzustellender Größen, d.h. zumindest den mindestens einen Parameter P des Frequenzfilters 9 und die zweite Laufzeitverzögerung T2 und gegebenenfalls auch weitere Größen wie beispielsweise den ersten Wichtungsfaktor $\gamma$ und/oder den zweiten Wichtungsfaktor $\beta$. Alternativ ist es möglich, dass die Wichtungsfaktoren $\gamma$, $\beta$ fest vorgegeben sind. Insbesondere können sie auf den Wert 1 festgesetzt sein.

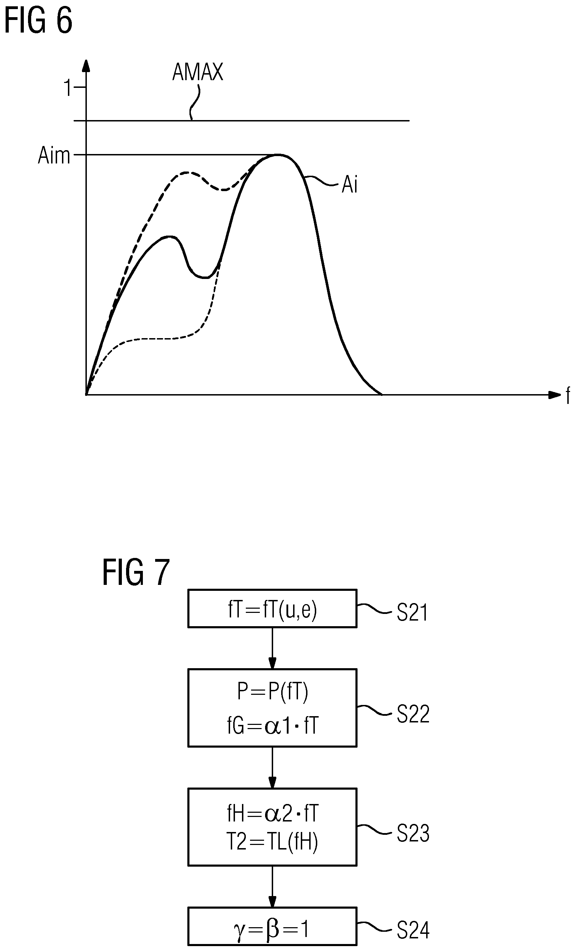

In einem Schritt S13 ermittelt die Ermittlungseinrichtung 15 in diesem Fall für den Vektor Vi die zugehörige Verstärkung Ai als Funktion der Frequenz f. Die Ermittlungseinrichtung 15 bildet also - als Funktion der Frequenz f - das Verhältnis des Signals sv am Ausgang des vorderen Pufferspeichers 10 und des Anregungssignals u. FIG 6 zeigt rein beispielhaft in durchgezogenen Linien die sich ergebende Verstärkung Ai. Im Rahmen der Ermittlung des Signals sv verwertet die Ermittlungseinrichtung 15 die Übertragungsfunktion G.

In einem Schritt S14 ermittelt die Ermittlungseinrichtung 15 den Maximalwert Aim der Verstärkung Ai. In einem Schritt S15 prüft die Ermittlungseinrichtung 15, ob der Maximalwert Aim unterhalb einer vorbestimmten Schwelle AMAX liegt. Die Schwelle AMAX ist entsprechend der Darstellung in FIG 6 ihrerseits kleiner als 1. Wenn dies nicht der Fall ist, wird der Vektor Vi in einem Schritt S16 verworfen. Anderenfalls wird der Vektor Vi in einem Schritt S17 als "Kandidat" für den später gültigen Vektor Vi vorselektiert. In einem Schritt S18 prüft die Ermittlungseinrichtung 15, ob sie die Schritte S12 bis S17 bereits für alle erforderlichen Vektoren Vi ausgeführt hat, ob also der Index i seinen Endwert erreicht hat. Wenn dies nicht der Fall ist, geht die Ermittlungseinrichtung 15 zum Schritt S12 zurück, in dem sie einen neuen Vektor Vi bestimmt. Anderenfalls geht die Ermittlungseinrichtung 15 zu einem Schritt S19 über.

Im Schritt S19 ermittelt die Einstelleinrichtung 15 anhand der im Schritt S17 vorselektierten Vektoren Vi denjenigen Vektor Vi, bei dem die Grenzfrequenz fG des Frequenzfilters 9 maximal ist. Gemäß diesem Vektor Vi erfolgt dann in einem Schritt S20 die Einstellung des mindestens einen Parameters P des Frequenzfilters 9 und der zweiten Laufzeitverzögerung T2.

Im Ergebnis bewertet die Einstelleinrichtung somit die Vektoren Vi gemäß einem Optimierungskriterium, wobei das Optimierungskriterium als (zwangsweise) einzuhaltende Randbedingung enthält, dass die Verstärkung Ai als Funktion der Frequenz f unterhalb der vorbestimmten Schwelle AMAX bleibt, und weiterhin der Vektor Vi umso besser bewertet wird, je höher die Grenzfrequenz fG des Frequenzfilters 9 ist.

In Versuchen hat sich gezeigt, dass die zweite Laufzeitverzögerung T2 kritisch sein kann, d.h. dass es bereits bei einer geringfügig abweichenden zweiten Laufzeitverzögerung T2 zu einer deutlichen Änderung der sich ergebenden Verstärkung Ai als Funktion der Frequenz f kommen kann. Vorzugsweise wird die Vorgehensweise von FIG 5 daher dahingehend modifiziert, dass für den jeweiligen Vektor Vi im Rahmen des Schrittes S12 zwar eine bestimmte (ergänze: einzige, feste) zweite Laufzeitverzögerung T2 bestimmt wird, im Rahmen des Schrittes S13 jedoch jeweils mehrfach für mehrere Werte der zweiten Laufzeitverzögerung T2 die jeweils zugehörige Verstärkung Ai als Funktion der Frequenz f ermittelt wird. Diese Werte definieren ein Intervall um die durch den Vektor Vi definierte zweite Laufzeitverzögerung T2 herum. Für die Grenzen T2u, T2o dieses Intervalls gelten entweder die Beziehungen

$$\frac{T2 - T2u}{T2} = k1 \qquad (7)$$

$$\frac{T2o - T2}{T2} = k2 \qquad (8)$$

oder die Beziehungen

$$T2 - T2u = k3 \qquad (9)$$

$$T2o - T2 = k4 \qquad (10)$$

wobei k1 bis k4 Konstanten größer 0 sind. Die Konstanten k1 und k2 können, nicht aber müssen den gleichen Wert aufweisen. Ebenso können, nicht aber müssen die Konstanten k3 und k4 den gleichen Wert aufweisen. Beispielsweise im Falle der Anwendung der Gleichungen (7) und (8) können die Konstanten k1 und k2 insbesondere Werte zwischen 0,15 und 0,25 aufweisen.

Wenn die Ermittlung des Schrittes S13 für mehrere Werte der zweiten Laufzeitverzögerung T2 erfolgt, ermittelt die Ermittlungseinrichtung 15 im Schritt S14 den Maximalwert Aim der Verstärkung Ai laufzeitübergreifend für alle bei der Ausführung des jeweiligen Schrittes S13 ermittelten Verstärkungen Ai.

Mittels der obenstehend in Verbindung mit den FIG 4 bis 6 erläuterten Vorgehensweise ist eine stabile, robuste und optimale bzw. nahezu optimale Parametrierung des Kompensationskreises 5 in automatisierter Weise möglich. Diese Vorgehensweise setzt jedoch voraus, dass die Übertragungsfunktion G zuverlässig ermittelt werden kann. Dies ist jedoch nicht stets der Fall. Beispielsweise bei Druckmaschinen - aber auch bei manchen anderen Produktionsmaschinen und teilweise auch bei Werkzeugmaschinen - ist die Übertragungsfunktion G zeitvariabel und/oder nichtlinear, d.h. von der Amplitude des Anregungssignals u abhängig. In derartigen Fällen führt die bisher erläuterte Vorgehensweise oftmals nur zu unbefriedigenden Ergebnissen. In derartigen Fällen empfiehlt sich eine alternative Vorgehensweise, die nachstehend in Verbindung mit FIG 7 näher erläutert wird.

FIG 7 zeigt - analog zu FIG 5 - eine mögliche Implementierung des Schrittes S4 von FIG 4. Gemäß FIG 7 ermittelt die Einstelleinrichtung 15 in einem Schritt S21 eine niedrigste Tilgerfrequenz fT des geschlossenen Regelkreises. Die Ermittlung des Schrittes S21 basiert auf der Auswertung des Anregungssignals u und des Ergebnissignals e. In diesem Fall bestimmt die Einstelleinrichtung 15 in einem Schritt S22 den mindestens einen Parameter P des Frequenzfilters 9 derart, dass die Grenzfrequenz fG des Frequenzfilters 9 einem vorbestimmten ersten Prozentsatz $\alpha1$ der Til-gerfrequenz fT entspricht. Der erste Prozentsatz $\alpha1$ kann beispielsweise zwischen 30 % und 70 % liegen, insbesondere zwischen 40 % und 60 %. Insbesondere ein Wert von etwa 50 % hat sich in der Praxis als vorteilhaft erwiesen. Weiterhin bestimmt die Einstelleinrichtung 15 in einem Schritt S22 eine Hilfsfrequenz fH. Die Hilfsfrequenz fH liegt unterhalb der Grenzfrequenz fG. Beispielsweise kann die Hilfsfrequenz fH gleich einem zweiten Prozentsatz $\alpha2$ der Grenzfrequenz fG sein. Der zweite Prozentsatz $\alpha2$ kann beispielsweise zwischen 30 % und 70 % liegen, insbesondere zwischen 40 % und 60 %. Insbesondere ein Wert von etwa 50 % hat sich in der Praxis als vorteilhaft erwiesen. Sodann bestimmt die Einstelleinrichtung 15 in einem Schritt S23 für die Hilfsfrequenz fH die zugehörige Regelkreislaufzeit TL und stellt die zweite Laufzeitverzögerung T2 auf die Regelkreislaufzeit TL ein. Schließlich setzt die Einstelleinrichtung 15 in einem Schritt S24 den ersten Wichtungsfaktor $\gamma$ und den zweiten Wichtungsfaktor $\beta$ auf vorbestimmte Werte fest. Die beiden Wichtungsfaktoren $\beta$, $\gamma$ können beispielsweise beide auf den Wert 1 gesetzt werden.

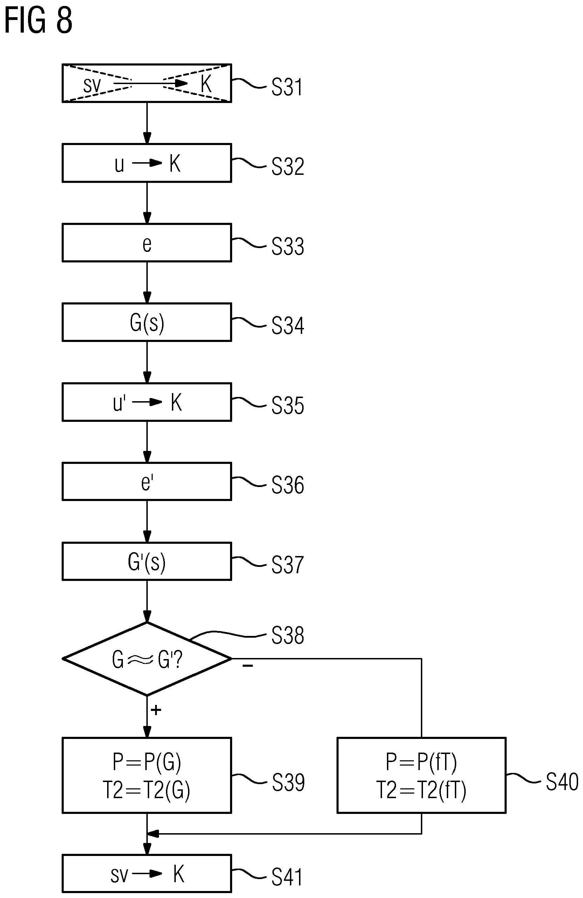

Es ist sogar möglich, die beiden prinzipiellen Vorgehensweisen - also die Vorgehensweise der FIG 4 und 5 einerseits und die Vorgehensweise von FIG 7 andererseits - miteinander zu kombinieren. In diesem Fall wird zunächst versucht, ob mittels der Vorgehensweise der FIG 4 und 5 eine sinnvolle und zuverlässige Einstellung der Parameter P des Frequenzfilters 9 und der zweiten Laufzeitverzögerung T2 möglich ist. Wenn dies hingegen nicht möglich ist, erfolgt die Einstellung der Parameter P des Frequenzfilters 9 und der zweiten Laufzeitverzögerung T2 gemäß der Vorgehensweise von FIG 7. Dies wird nachstehend in Verbindung mit FIG 8 näher erläutert.

Gemäß FIG 8 trennt die Einstelleinrichtung 15 zunächst in einem Schritt S31 die Verbindung des Frequenzfilters 9 mit dem hinteren Pufferspeicher 11 auf. Weiterhin führt die Einstelleinrichtung 15 in einem Schritt S32 dem hinteren Pufferspeicher 11 und dem hinteren Knotenpunkt 3 stattdessen als Kompensationssignal K ein Anregungssignal u zu. Weiterhin erfasst die Einstelleinrichtung 15 in einem Schritt S33 ein Ergebnissignal e, das durch das Anregungssignal u hervorgerufen wird. In einem Schritt S34 ermittelt die Einstelleinrichtung 15 durch Auswertung des Anregungssignals u und des Ergebnissignals e die Übertragungsfunktion G(s) des geschlossenen Regelkreises. Die Schritte S31 bis S33 und S34 korrespondieren mit den Schritten S1 bis S3 von FIG 4 und dem Schritt S11 von FIG 5.

Sodann führt die Einstelleinrichtung 15 Schritte S35 und S36 aus. Die Schritte S35 und S36 korrespondieren inhaltlich mit den Schritten S32 und S33. Anstelle des Anregungssignals u des Schrittes S32 wird jedoch ein anderes Anregungssignal u' herangezogen, nachfolgend als weiteres Anregungssignal u' bezeichnet. Demzufolge ergibt sich auch ein anderes Ergebnissignal e', nachfolgend als weiteres Ergebnissignal e' bezeichnet. In einem Schritt S37 ermittelt die Einstelleinrichtung 15 durch Auswertung des weiteren Anregungssignals u' und des weiteren Ergebnissignals e' eine Übertragungsfunktion G'(s) des geschlossenen Regelkreises, nachfolgend als weitere Übertragungsfunktion G'(s) bezeichnet. Der Schritt S37 korrespondiert mit dem Schritt S34, basiert jedoch auf dem weiteren Anregungssignal u' und dem weiteren Ergebnissignal e'.

Im Idealfall sind die beiden Übertragungsfunktionen G, G' identisch. In der Realität können sie voneinander abweichen. Die Ermittlungseinrichtung 15 prüft daher in einem Schritt S38, ob die Übertragungsfunktionen G, G' übereinstimmen bzw. zumindest in hinreichendem Umfang übereinstimmen. Wenn dies der Fall ist, erfolgt in einem Schritt S39 die Einstellung der Parameter P des Frequenzfilters 9 und der zweiten Laufzeitverzögerung T2 sowie gegebenenfalls weiterer Größen basierend auf der Übertragungsfunktion G oder der weiteren Übertragungsfunktion G'. Der Schritt S39 korrespondiert inhaltlich mit den Schritten S12 bis S20 von FIG 5. Anderenfalls erfolgt in einem Schritt S40 die Einstellung der Parameter P des Frequenzfilters 9 und der zweiten Laufzeitverzögerung T2 sowie gegebenenfalls der weiteren Größen basierend auf der Tilgerfrequenz fT. Der Schritt S40 korrespondiert inhaltlich mit den Schritten S21 bis S24 von FIG 7. Danach stellt die Einstelleinrichtung 15 in einem Schritt S41 - analog zum Schritt S5 von FIG 4 - die Verbindung des Frequenzfilters 9 mit dem hinteren Pufferspeicher 11 wieder her.

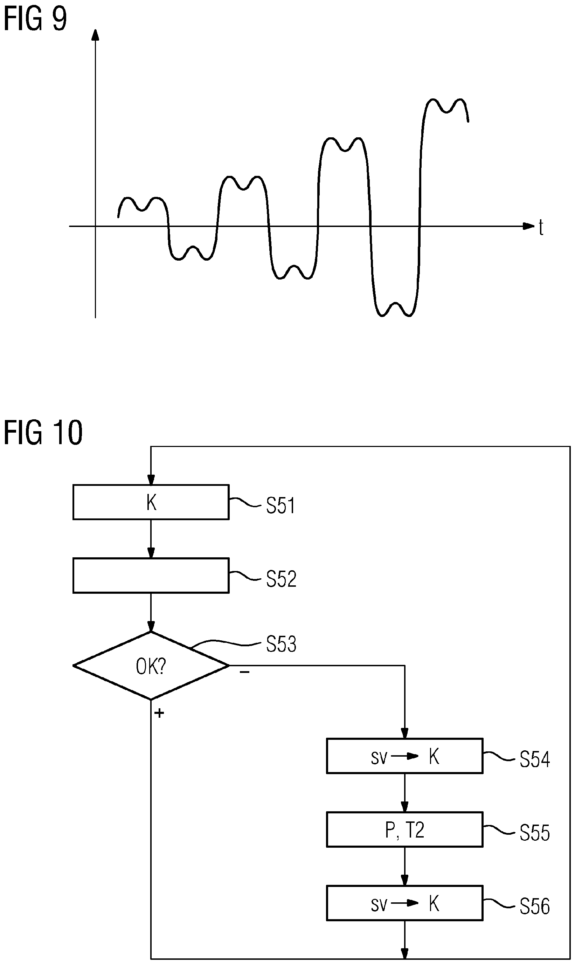

Unabhängig davon, auf welche Weise die Einstellung der Parameter P des Frequenzfilters 9 und der zweiten Laufzeitverzögerung T2 vorgenommen wird, wird die Einstellung derart vorgenommen, dass die Regeleinrichtung stabil arbeitet. Wenn sich jedoch im Laufe des Betriebs der Regelstrecke 1 die Übertragungsfunktion G(s) des geschlossenen Regelkreises ändert, kann es entsprechend der Darstellung in FIG 9 geschehen, dass der Kompensationskreis 5 instabil wird. In diesem Fall schaukelt sich das Kompensationssignal K nach und nach immer weiter auf. Dies kann Schäden an der gesteuerten Anlage bzw. Maschine (welche die Regelstrecke 1 beinhaltet) hervorrufen. Um derartige Schäden zu vermeiden, weist die Regeleinrichtung - siehe FIG 1 - vorzugsweise eine Überwachungseinrichtung 16 auf. Im Normalbetrieb der Regeleinrichtung überwacht die Überwachungseinrichtung 16 automatisch den zeitlichen Verlauf des Kompensationssignals K. Insbesondere greift die Überwachungseinrichtung 16 im Normalbetrieb gemäß FIG 10 in einem Schritt S51 das Kompensationssignal ab und wertet es in einem Schritt S52 aus. Beispielsweise kann die Überwachungseinrichtung 16 ermitteln, ob der Betrag des Kompensationssignals K einen vorbestimmten Schwellenwert überschreitet oder ob das Kompensationssignal K über mehrere Perioden der Störung z hinweg stets größer geworden ist als in der jeweils vorherigen Periode. Eine geeignete Anzahl an Perioden kann beispielsweise zwischen 4 und 10 liegen. Auch ist es möglich, eine Regeldifferenz $\delta x$ zu ermitteln, die maximal auftritt, wenn der Kompensationskreis 5 inaktiv geschaltet ist. In diesem Fall kann beispielsweise der vorbestimmte Schwellenwert durch Multiplikation dieses Maximalwertes mit einem Faktor ermittelt werden.

In einem Schritt S53 prüft die Überwachungseinrichtung 16, ob ein derartiger Fall von Instabilität des Kompensationssignals K vorliegt. Wenn dies der Fall ist, geht die Überwachungseinrichtung 16 zu einem Schritt S54 über. Im Schritt S54 trennt die Einstelleinrichtung 15 analog zum Schritt S1 von FIG 4 die Verbindung des Frequenzfilters 9 mit dem hinteren Pufferspeicher 11 auf. Es erfolgt daher zwar weiterhin eine Regelung der Regelstrecke 1 durch den Regler 4, das Aufschalten des Kompensationssignals K auf die Regeldifferenz δx wird jedoch im Ergebnis unterdrückt.

Es ist möglich, dass die Vorgehensweise von FIG 10 damit beendet ist. In diesem Fall unterdrückt die Überwachungseinrichtung 16 im Rahmen des Schrittes S54 lediglich, dass das Ausgangssignal sv des vorderen Pufferspeichers 10 dem hinteren Pufferspeicher 11 und dem hinteren Knotenpunkt 3 zugeführt wird und damit als Kompensationssignal K verwendet wird. Alternativ ist es möglich, dass zusätzlich Schritte S55 und S56 vorhanden sind. Im Schritt S55 stellt die Überwachungseinrichtung 16 den mindestens einen Parameter P des Frequenzfilters 9 und/oder die zweite Laufzeitverzögerung T2 auf andere Werte ein. Insbesondere kann die Überwachungseinrichtung 16 eine entsprechende Ansteuerung der Einstelleinrichtung 15 bewirken oder mit der Einstelleinrichtung 15 eine gemeinsame Einrichtung bilden. Im Schritt S56 stellt die Einstelleinrichtung 15 - analog zum Schritt S5 von FIG 4 - die Verbindung des Frequenzfilters 9 mit dem hinteren Pufferspeicher 11 wieder her. Das Kompensationssignal K wird also wieder auf die Regeldifferenz δx aufgeschaltet.

Im Rahmen der Implementierung der Schritte S55 und S56 ist es beispielsweise möglich, dass die Überwachungseinrichtung 16 prüft, ob die Parameter P des Frequenzfilters 9 und/oder die zweite Laufzeitverzögerung T2 basierend auf der Übertragungsfunktion G(s) oder basierend auf der Tilgerfrequenz fT bestimmt wurden. Im erstgenannten Fall kann die Überwachungseinrichtung 16 - sozusagen als Rückfalllinie - im Schritt S55 eine Ermittlung basierend auf der Tilgerfrequenz fT durchführen bzw. auslösen, im zweitgenannten Fall die Schritte S55 und S56 nicht ausführen. Auch ist es möglich, - sei es als weitere Rückfalllinie, sei es direkt und unmittelbar - anstelle der auf erfindungsgemäße Weise ermittelten Werte für den mindestens einen Parameter P des Frequenzfilters 9 und die zweite Laufzeitverzögerung T2 vorab bestimmte Werte zu verwenden. In diesem Fall kann unter Umständen weiterhin eine Fehlerkompensation erfolgen, die zwar suboptimal arbeitet, dafür aber sicher stabil bleibt.

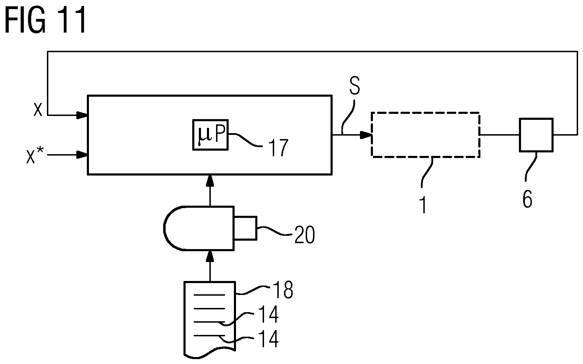

Die Regeleinrichtung ist vorzugsweise entsprechend der Darstellung in FIG 11 als softwareprogrammierbare Regeleinrichtung ausgebildet. Sie umfasst also einen Mikroprozessor 17.

Die Regeleinrichtung ist in diesem Fall mit einem Softwaremodul 18 programmiert. Aufgrund der Programmierung mit dem Softwaremodul 18 ist die Regeleinrichtung erfindungsgemäß ausgebildet. Das Softwaremodul 18 umfasst Maschinencode 19. Die Abarbeitung des Maschinencodes 19 durch die Regeleinrichtung bewirkt somit, dass die Regeleinrichtung erfindungsgemäß ausgebildet ist, also den vorderen und dem hinteren Knotenpunkt 2, 3, den Regler 4, den Kompensationskreis 5 (einschließlich dessen Komponenten 8 bis 14), den Abgreifpunkt 7 und zumindest die Einstelleinrichtung 15, gegebenenfalls auch die Überwachungseinrichtung 16 und deren obenstehend erläuterten Wirkungsweisen implementiert.

Das Softwaremodul 18 kann der Regeleinrichtung auf prinzipiell beliebige Weise zugeführt werden. Insbesondere kann das Softwaremodul 18 auf einem Datenträger 20 in maschinenlesbarer Form gespeichert sein. Die Darstellung in FIG 11, in welcher der Datenträger 20 als USB-Memorystick dargestellt ist, ist jedoch rein beispielhaft und nicht beschränkend zu verstehen.

Zusammengefasst betrifft die vorliegende Erfindung somit folgenden Sachverhalt:

Zur automatischen Parametrierung eines Kompensationskreises 5 einer lernfähigen Regelung weist eine Regeleinrichtung eine Einstelleinrichtung 15 auf, die in einem Einstellbetrieb der Regeleinrichtung automatisch als Kompensationssignal K einem Aufschaltpunkt des Regelkreises ein Anregungssignal u zuführt und ein durch das Anregungssignal u hervorgerufenes Ergebnissignal e erfasst. Basierend auf einer Auswertung des Anregungssignals u und des Ergebnissignals e stellt die Einstelleinrichtung 15 mindestens einen Parameter P eines Frequenzfilters 9 des Kompensationskreises 5 und die Laufzeitverzögerung T2 eines Pufferspeichers 11 ein, wobei der Pufferspeicher 11 derjenige Pufferspeicher ist, dessen Ausgangssignal R innerhalb des Kompensationskreises 5 mit einem Merkfaktor gewichtet rückgekoppelt ist.

Die vorliegende Erfindung weist viele Vorteile auf. So ist die Parametrierung nicht nur automatisierbar. Vielmehr ist in vielen Fällen sogar eine Parametrierung des Kompensationskreises 5 zu erzielen, bei der die Grenzfrequenz fG des Frequenzfilters 9 im hohen 2-stelligen Hertz-Bereich liegt, beispielsweise oberhalb von 70 Hz. Durch die Überwachungseinrichtung 16 kann auch bei variierender Übertragungsfunktion G eine Schädigung der Regelstrecke 1 zuverlässig ausgeschlossen werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der nur durch die Ansprüche eingeschränkt ist.

**Patentansprüche**

1.  Regeleinrichtung zum Regeln einer Regelstrecke (1),

    - wobei die Regeleinrichtung einen vorderen Knotenpunkt (2), einen hinteren Knotenpunkt (3), einen zwischen dem vorderen und dem hinteren Knotenpunkt (2, 3) angeordneten äußeren Abgreifpunkt (7), einen Regler (4) und einen Kompensationskreis (5) aufweist,
    - wobei der Kompensationskreis (5) einen inneren Knotenpunkt (8), ein Frequenzfilter (9), einen vorderen Pufferspeicher (10) und einen hinteren Pufferspeicher (11) aufweist,
    - wobei der vordere Knotenpunkt (2) einen ausgangsseitig der Regelstrecke (1) mittels einer Messeinrichtung (6) erfassten Istwert (x) und einen korrespondierenden Sollwert (x*) entgegennimmt und durch Bildung von deren Differenz eine Regeldifferenz ($\delta$x) ermittelt,
    - wobei der hintere Knotenpunkt (3) die Regeldifferenz ($\delta$x) und ein Kompensationssignal (K) entgegennimmt und dem Regler (4) ein durch Addieren von Regeldifferenz ($\delta$x) und Kompensationssignal (K) gebildetes äußeres Summensignal (s1) zuführt,
    - wobei der Regler anhand des äußeren Summensignals (s1) ein Stellsignal (S) für die Regelstrecke (1) ermittelt und an die Regelstrecke (1) ausgibt,
    - wobei der innere Knotenpunkt (8) durch Addieren der an dem äußeren Abgreifpunkt (7) abgegriffenen und mit einem ersten Wichtungsfaktor ($\gamma$) gewichteten Regeldifferenz ($\delta$x) und eines mit einem zweiten Wichtungsfaktor ($\beta$) gewichteten Rückkopplungssignals (R) ein inneres Summensignal (s2) bildet und dem Frequenzfilter (9) zuführt,
    - wobei das Frequenzfilter (9) eine Frequenzfilterung durchführt und das gefilterte Signal (sF) dem vorderen Pufferspeicher (10) zuführt,
    - wobei der vordere Pufferspeicher (10) das gefilterte Signal (sf) um eine erste Laufzeitverzögerung (T1) verzögert und das entsprechend verzögerte Signal (sv) als Ausgangssignal (sv) ausgibt,
    - wobei der hintere Pufferspeicher (11) das Kompensationssignal (K) um eine zweite Laufzeitverzögerung (T2) verzögert und das entsprechend verzögerte Signal (R) als Rückkopplungssignal (R) ausgibt,
    - wobei in einem Normalbetrieb der Regeleinrichtung das Ausgangssignal (sv) des vorderen Pufferspeichers (10) als Kompensationssignal (K) herangezogen wird,

    **dadurch gekennzeichnet,**
    **dass** die Regeleinrichtung eine Einstelleinrichtung (15) aufweist und dass die Einstelleinrichtung (15) in einem Einstellbetrieb der Regeleinrichtung automatisch

    - die Verwendung des Ausgangssignals (sv) des vorderen Pufferspeichers (10) als Kompensationssignal (K) unterdrückt,
    - dem hinteren Pufferspeicher (11) und dem hinteren Knotenpunkt (3) stattdessen als Kompensationssignal (K) ein Anregungssignal (u) zuführt,
    - ein durch das Anregungssignal (u) hervorgerufenes Ergebnissignal (e) erfasst, wobei das Ergebnissignal (e) die Regeldifferenz ($\delta$x), das innere Summensignal (s2), das Ausgangssignal (sf) des Frequenzfilters (9) oder das Ausgangssignal (sv) des vorderen Pufferspeichers (10) ist, und
    - basierend auf einer Auswertung des Anregungssignals (u) und des Ergebnissignals (e) zumindest mindestens einen Parameter (P) des Frequenzfilters (9) und die zweite Laufzeitverzögerung (T2) einstellt.

2.  Regeleinrichtung nach Anspruch 1,
    **dadurch gekennzeichnet,**
    **dass** die Einstelleinrichtung (15) im Rahmen der Auswertung des Anregungssignals (u) und des Ergebnissignals (e) eine Übertragungsfunktion (G) des geschlossenen Regelkreises ermittelt und dass die Einstelleinrichtung (15) den mindestens einen Parameter (P) des Frequenzfilters (9) und die zweite Laufzeitverzögerung (T2) basierend auf einer Auswertung der Übertragungsfunktion (G) des geschlossenen Regelkreises einstellt.

3.  Regeleinrichtung nach Anspruch 2,
    **dadurch gekennzeichnet,**

    - **dass** die Einstelleinrichtung (15) eine Mehrzahl von Vektoren (Vi) ermittelt, die als Vektorkomponenten jeweils zumindest den mindestens einen Parameter (P) des Frequenzfilters (9) und die zweite Laufzeitverzögerung (T2) enthalten,
    - **dass** die Einstelleinrichtung (15) unter Verwertung der Übertragungsfunktion (G) für die Mehrzahl von Vektoren (Vi) jeweils ein Verhältnis (Ai) des Ausgangssignals (sv) des vorderen Pufferspeicher (10) zum Anregungssignal (u) als Funktion der Frequenz (f) ermittelt,

- **dass** die Einstelleinrichtung (15) den mindestens einen Parameter (P) des Frequenzfilters (9) und die zweite Laufzeitverzögerung (T2) gemäß demjenigen Vektor (Vi) einstellt, der gemäß einem vorbestimmten Optimierungskriterium als optimal bewertet wird,

- **dass** das Optimierungskriterium als einzuhaltende Randbedingung enthält, dass das Verhältnis (Ai) des Ausgangssignals (sv) des vorderen Pufferspeichers (10) zum Anregungssignal (u) als Funktion der Frequenz (f) unterhalb einer vorbestimmten Schwelle (AMAX) bleibt, die ihrerseits kleiner als 1 ist, und

- **dass** weiterhin der Vektor (Vi) umso besser bewertet wird, je höher die Grenzfrequenz (Fg) des Frequenzfilters (9) ist.

4. Regeleinrichtung nach Anspruch 1,
**dadurch gekennzeichnet,**
**dass** die Einstelleinrichtung (15) basierend auf der Auswertung des Anregungssignals (u) und des Ergebnissignals (e) eine niedrigste Tilgerfrequenz (fT) des geschlossenen Regelkreises ermittelt und dass die Einstelleinrichtung (15) den mindestens einen Parameter (P) des Frequenzfilters (9) derart bestimmt, dass die Grenzfrequenz (fG) des Frequenzfilters (9) einem vorbestimmten Prozentsatz ($\alpha$1) der Tilgerfrequenz (fT) entspricht.

5. Regeleinrichtung nach Anspruch 4,
**dadurch gekennzeichnet,**
**dass** die Einstelleinrichtung (15) bei einer Hilfsfrequenz (fH), die kleiner als die anhand der Tilgerfrequenz (fT) ermittelte Grenzfrequenz (fG) des Frequenzfilters (9) ist, eine Regelkreislaufzeit (TL) für die Hilfsfrequenz (fH) ermittelt, wobei die Regelkreislaufzeit (TL) diejenige Zeit ist, die vergeht, bis ein dem vorderen Knotenpunkt (2) zugeführtes Signal eine Änderung des Istwerts (x) bewirkt, und die zweite Laufzeitverzögerung (T2) auf die Regelkreislaufzeit (TL) einstellt.

6. Regeleinrichtung nach Anspruch 4 oder 5,
**dadurch gekennzeichnet,**
**dass** die Einstelleinrichtung (15) den ersten Wichtungsfaktor ($\gamma$) und den zweiten Wichtungsfaktor ($\beta$) auf vorbestimmte Werte festsetzt.

7. Regeleinrichtung nach Anspruch 1,
**dadurch gekennzeichnet,**
**dass** die Einstelleinrichtung vor oder nach dem Zuführen des Anregungssignals (u) zum hinteren Pufferspeicher (11) und zum hinteren Knotenpunkt (3)

- die Verwendung des Ausgangssignals (sv) des vorderen Pufferspeichers (10) als Kompensationssignal (K) unterdrückt,
- dem hinteren Pufferspeicher (11) und dem hinteren Knotenpunkt (3) als Kompensationssignal (K) mindestens ein weiteres Anregungssignal (u') zuführt,
- das dadurch hervorgerufene Ergebnissignal (e') erfasst, wobei das nunmehr hervorgerufene Ergebnissignal (e') die nunmehr hervorgerufene Regeldifferenz ($\delta$x), das nunmehr hervorgerufene innere Summensignal (s2), das nunmehr hervorgerufene Ausgangssignal (sf) des Frequenzfilters (9) oder das nunmehr hervorgerufene Ausgangssignal (sv) des vorderen Pufferspeichers (10) ist, und
- basierend auf einer Auswertung des Anregungssignals (u) und des Ergebnissignals (e) einerseits und des weiteren Anregungssignals (u') und des dadurch hervorgerufenen Ergebnissignals (e') andererseits entscheidet, ob sie die Einstellung des mindestens einen Parameters (P) des Frequenzfilters (9) und der zweiten Laufzeitverzögerung (T2) gemäß Anspruch 2 oder 3 einerseits oder Anspruch 4, 5 oder 6 andererseits vornimmt.

8. Regeleinrichtung nach einem der obigen Ansprüche,
**dadurch gekennzeichnet,**

- **dass** die Regeleinrichtung eine Überwachungseinrichtung (16) aufweist,
- **dass** die Überwachungseinrichtung (16) im Normalbetrieb der Regeleinrichtung automatisch den zeitlichen Verlauf des Kompensationssignals (K) überwacht und
- **dass** die Überwachungseinrichtung (16) das Zuführen des Ausgangssignals (sv) des vorderen Pufferspeichers (10) zum hinteren Knotenpunkt (3) unterdrückt und/oder den mindestens einen Parameter (P) des Frequenzfilters (9) und/oder die zweite Laufzeitverzögerung (T2) auf andere Werte einstellt, sobald die Überwachung des zeitlichen Verlaufs des Kompensationssignals (K) eine Instabilität des Kompensationskreises anzeigt.

9. Regeleinrichtung nach einem der obigen Ansprüche,
**dadurch gekennzeichnet,**
**dass** sie als softwareprogrammierbare Regeleinrichtung ausgebildet ist und mit einem Softwaremodul (18) programmiert ist, so dass sie aufgrund der Programmierung mit dem Softwaremodul (18) nach einem der obigen Ansprüche ausgebildet ist.

10. Regeleinrichtung nach einem der obigen Ansprüche,
**dadurch gekennzeichnet,**
**dass** sie zur Steuerung einer Achse einer Druckmaschine verwendet wird.

11. Softwaremodul, das Maschinencode (19) umfasst, dessen Abarbeitung durch eine softwareprogrammierbare Regeleinrichtung bewirkt, dass die Regeleinrichtung gemäß einem der Ansprüche 1 bis 9 ausgebildet ist.

12. Softwaremodul nach Anspruch 11,
**dadurch gekennzeichnet,**
**dass** es auf einem Datenträger (20) in maschinenlesbarer Form gespeichert ist.

**Claims**

1. Control facility for controlling a controlled system (1),

   - wherein the control facility has a front node (2), a back node (3), an external tapping point (7) arranged between the front and the back node (2, 3), a controller (4) and a compensating circuit (5),
   - wherein the compensating circuit (5) has an inner node (8), a frequency filter (9), a front buffer (10) and a back buffer (11),
   - wherein the front node (2) receives an actual value (x) detected at the output of the controlled system (1) by means of a measuring device (6), and a corresponding desired value (x*), and determines a control difference ($\delta$x) by forming the difference thereof,
   - wherein the back node (3) receives the control difference ($\delta$x) and a compensation signal (K) and supplies the controller (4) with an external sum signal (s1) formed by adding control difference ($\delta$x) and compensation signal (K),
   - wherein, using the external sum signal (s1), the controller determines a control signal (S) for the controlled system (1) and outputs it to the controlled system (1),
   - wherein the inner node (8) forms an internal sum signal (s2) by adding the control difference ($\delta$x) tapped at the external tapping point (7) and weighted with a first weighting factor ($\gamma$), and a feedback signal (R) weighted with a second weighting factor ($\beta$), and supplies it to the frequency filter (9),
   - wherein the frequency filter (9) carries out a frequency filtering and supplies the filtered signal (sF) to the front buffer (10),
   - wherein the front buffer (10) delays the filtered signal (sf) by a first propagation delay (T1) and outputs the correspondingly delayed signal (sv) as an output signal (sv),
   - wherein the back buffer (11) delays the compensation signal (K) by a second propagation delay (T2) and outputs the correspondingly delayed signal (R) as a feedback signal (R),
   - wherein, during normal operation of the control facility, the output signal (sv) of the front buffer (10) is used as the compensation signal (K),

   **characterised in that**
   the control facility has a setting device (15) and that in a setting mode of the control facility the setting device (15) automatically

   - suppresses use of the output signal (sv) of the front buffer (10) as the compensation signal (K),
   - supplies the back buffer (11) and the back node (3) with an excitation signal (u) as the compensation signal (K) instead,
   - detects a result signal (e) produced by the excitation signal (u), wherein the result signal (e) is the control difference ($\delta$x), the internal sum signal (s2), the output signal (sf) of the frequency filter (9) or the output signal (sv) of the front buffer (10), and

- based on an evaluation of the excitation signal (u) and the result signal (e), sets at least one parameter (P) of the frequency filter (9) and the second propagation delay (T2).

2. Control facility according to claim 1,
**characterised in that**
during the course of evaluation of the excitation signal (u) and result signal (e), the setting device (15) determines a transfer function (G) of the closed control loop and that the setting device (15) sets the at least one parameter (P) of the frequency filter (9) and the second propagation delay (T2) on the basis of an evaluation of the transfer function (G) of the closed control loop.

3. Control facility according to claim 2,
**characterised in that**

- the setting device (15) determines a plurality of vectors (Vi) which include as vector components at least the at least one parameter (P) of the frequency filter (9) and the second propagation delay (T2) in each case,
- the setting device (15), using the transfer function (G) for the plurality of vectors (Vi), determines a ratio (Ai) of the output signal (sv) of the front buffer (10) to the excitation signal (u) as a function of the frequency (f) in each case,
- the setting device (15) sets the at least one parameter (P) of the frequency filter (9) and the second propagation delay (T2) according to the vector (Vi) which is rated as being optimum according to a predetermined optimisation criterion,
- as a boundary condition to be observed, the optimisation criterion includes that the ratio (Ai) of the output signal (sv) of the front buffer (10) to the excitation signal (u) as a function of the frequency (f) remains below a predetermined threshold (AMAX) which, in turn, is less than 1, and
- furthermore, the vector (Vi) is rated all the better the higher the limit frequency (Fg) of the frequency filter (9) is.

4. Control facility according to claim 1,
**characterised in that**
the setting device (15) determines a lowest absorber frequency (fT) of the closed control loop on the basis of the evaluation of the excitation signal (u) and result signal (e) and that the setting device (15) determines the at least one parameter (P) of the frequency filter (9) in such a way that the limit frequency (fG) of the frequency filter (9) matches a predetermined percentage ($\alpha$1) of the absorber frequency (fT).

5. Control facility according to claim 4,
**characterised in that**
at an auxiliary frequency (fH), which is less than the limit frequency (fG) of the frequency filter (9) determined using the absorber frequency (fT), the setting device (15) determines a control loop propagation time (TL) for the auxiliary frequency (fH), wherein the control loop propagation time (TL) is the time that elapses until a signal fed to the front node (2) produces a change in the actual value (x), and sets the second propagation delay (T2) to the control loop propagation time (TL).

6. Control facility according to claim 4 or 5,
**characterised in that**
the setting device (15) fixes the first weighting factor ($\gamma$) and the second weighting factor ($\beta$) at predetermined values.

7. Control facility according to claim 1,
**characterised in that**
before or after feeding the excitation signal (u) to the back buffer (11) and the back node (3), the setting device

- suppresses the use of the output signal (sv) of the front buffer (10) as compensation signal (K),
- supplies the back buffer (11) and the back node (3) with at least one further excitation signal (u') as compensation signal (K),
- detects the result signal (e') produced thereby, wherein the result signal (e') now produced is the control difference ($\delta$x) now produced, the internal sum signal (s2) now produced, the output signal (sf) now produced of the frequency filter (9) or the output signal (sv) now produced of the front buffer (10), and
- on the basis of an evaluation of the excitation signal (u) and the result signal (e) on the one hand and the further excitation signal (u') and the result signal (e') produced as a result on the other hand, decides whether it sets the at least one parameter (P) of the frequency filter (9) and the second propagation delay (T2) according to claim 2 or 3 on the one hand or claim 4, 5 or 6 on the other hand.

8. Control facility according to one of the preceding claims,
   **characterised in that**

   - the control facility has a monitoring system (16),
   - during normal operation of the control facility, the monitoring system (16) automatically monitors the time characteristic of the compensation signal (K) and
   - the monitoring system (16) suppresses feeding of the output signal (sv) of the front buffer (10) to the back node (3) and/or sets the at least one parameter (P) of the frequency filter (9) and/or the second propagation delay (T2) to different values as soon as monitoring of the time characteristic of the compensation signal (K) demonstrates an instability of the compensating circuit.

9. Control facility according to one of the preceding claims,
   **characterised in that**
   it is designed as a software-programmable control facility and is programmed with a software module (18), so owing to programming with the software module (18) it is designed according to one of the preceding claims.

10. Control facility according to one of the preceding claims,
    **characterised in that**
    it is used to control an axle of a printing machine.

11. Software module, comprising machine code (19), whose processing by a software-programmable control facility causes the control facility to be designed according to one of claims 1 to 9.

12. Software module according to claim 11,
    **characterised in that**
    it is stored on a data carrier (20) in machine-readable form.

**Revendications**

1. Dispositif de réglage pour régler un système (1) asservi,

   - dans lequel le dispositif de réglage a un point (2) nodal avant, un point (3) nodal arrière, un point (7) de prélèvement extérieur, disposé entre le point (2) nodal avant et le point (3) nodal arrière, un régleur (4) et un circuit (5) de compensation,
   - dans lequel le circuit (5) de compensation a un point (8) nodal intérieur, un filtre (9) de fréquence, une mémoire (10) tampon avant et une mémoire (11) tampon arrière,
   - dans lequel le point (2) nodal avant reçoit une valeur (x) réelle, détectée du côté de la sortie du système (1) asservi au moyen d'un dispositif (6) de mesure, et une valeur (x*) de consigne correspondante, et détermine une différence (δx) de réglage en formant leur différence,
   - dans lequel le point (3) nodal arrière reçoit la différence (δx) de réglage et un signal (K) de compensation et envoie au régleur (4) un signal (s1) somme extérieur formé par addition de la différence (δx) de réglage et du signal (K) de compensation,
   - dans lequel le réglage détermine, à l'aide du signal (s1) somme extérieur, un signal (S) de commande du système (1) asservi et l'envoie au système (1) asservi,
   - dans lequel le point (8) nodal intérieur forme, par addition de la différence (δx) de réglage prélevée au point (7) de prélèvement extérieur et pondérée par un premier facteur (γ) de pondération et d'un signal (R) de réaction pondéré par un deuxième facteur (β) de réaction, un signal (s2) somme intérieur et l'envoie au filtre (9) de fréquence,
   - dans lequel le filtre (9) de fréquence effectue un filtrage de fréquence et envoie le signal (sF) filtré à la mémoire (10) tampon avant,
   - dans lequel la mémoire (10) tampon avant retarde le signal (sf) filtré d'un premier retard (T1) de temps de propagation et émet le signal (sv) retardé correspondant, comme signal (sv) de sortie,
   - dans lequel la mémoire (11) tampon arrière retarde le signal (K) de compensation d'un deuxième retard (T2) de temps de propagation et envoie le signal (R) retardé correspondant, comme signal (R) de réaction,
   - dans lequel, dans un fonctionnement normal du dispositif de réglage, le signal (sv) de sortie de la mémoire (10) tampon avant est mis à profit comme signal (K) de compensation,

**caractérisé**
**en ce que** le dispositif de réglage a un dispositif (15) de commande et **en ce que** le dispositif (15) de commande, dans un fonctionnement de commande du dispositif de réglage, automatiquement

- supprime l'utilisation du signal (sv) de sortie de la mémoire (10) tampon avant comme signal (K) de compensation,
- envoie à la mémoire (11) tampon arrière et au point (3) nodal arrière, au lieu de cela, comme signal (K) de compensation, un signal (u) d'excitation,
- détecte un signal (e) de résultat provoqué par le signal (u) d'excitation, le signal (e) de résultat étant la différence ($\delta$x) de réglage, le signal (s2) somme intérieur, le signal (sf) de sortie du filtre (9) de fréquence ou le signal (sv) de sortie de la mémoire (10) tampon avant et
- sur la base d'une exploitation du signal (u) d'excitation et du signal (e) de résultat, commande au moins un paramètre (P) du filtre (9) de fréquence et le deuxième retard (T2) de temps de propagation.

2. Dispositif de réglage suivant la revendication 1,
**caractérisé**
**en ce que** le dispositif (15) de commande détermine, dans le cadre de l'exploitation du signal (u) d'excitation et du signal (e) de résultat, une fonction (G) de transfert du circuit de réglage fermé et **en ce que** le dispositif (15) de commande commande le au moins un paramètre (P) du filtre (9) de fréquence et le deuxième retard (T2) de temps de propagation sur la base d'une exploitation de la fonction (G) de transfert du circuit de réglage fermé.

3. Dispositif de réglage suivant la revendication 2, **caractérisé**

- **en ce que** le dispositif (15) de commande détermine une pluralité de vecteurs (Vi), qui contiennent, comme composantes vectorielles, chacun au moins le au moins un paramètre (P) du filtre (9) de fréquence et le deuxième retard (T2) de temps de propagation,
- **en ce que** le dispositif (15) de commande détermine, en utilisant, la fonction (G) de transfert pour la pluralité de vecteurs (Vi), respectivement un rapport (Ai) du signal (sv) de sortie de la mémoire (10) tampon avant au signal (u) d'excitation, comme fonction de la fréquence (f),
- **en ce que** le dispositif (15) de commande commande le au moins un paramètre (P) du filtre (9) de fréquence et le deuxième retard (T2) de temps de propagation suivant le vecteur (Vi), qui est estimé comme optimum suivant un critère d'optimisation défini à l'avance,
- **en ce que** le critère d'optimisation comporte, comme condition aux limites à observer, que le rapport (Ai) du signal (sv) de sortie de la mémoire (10) tampon avant au signal (u) d'excitation, comme fonction de la fréquence (f), reste inférieur à un seuil (AMAX) défini à l'avance, qui, de son côté, est plus petit que 1 et
- **en ce qu'**en outre, le vecteur (Vi) est estimé d'autant mieux que la fréquence (Fg) limite du filtre (9) de fréquence est plus grande.

4. Dispositif de réglage suivant la revendication 1,
**caractérisé**
**en ce que** le dispositif (15) de commande détermine, sur la base de l'exploitation du signal (u) d'excitation et du signal (e) de résultat, une fréquence (fT) d'extinction la plus basse du circuit de réglage fermé et **en ce que** le dispositif (15) de commande détermine le au moins un paramètre (P) du filtre (9) de fréquence, de manière à ce que la fréquence (fG) limite du filtre (9) de fréquence corresponde à un pourcentage ($\alpha$1) défini à l'avance de la fréquence (fT) d'extinction.

5. Dispositif de réglage suivant la revendication 4,
**caractérisé**
**en ce que** le dispositif (15) de commande détermine, à une fréquence (fH) auxiliaire, qui est plus petite que la fréquence (fG) limite déterminée à l'aide de la fréquence (fT) d'extinction du filtre (9) de fréquence, un temps (TL) de propagation de circuit de réglage pour la fréquence (fH) auxiliaire, le temps (TL) de propagation de circuit de réglage étant le temps qui s'écoule jusqu'à ce qu'un signal, envoyé au point (2) nodal avant, provoque une variation de la valeur (x) réelle, et règle le deuxième retard (T2) de temps de propagation au temps (TL) de propagation de circuit de réglage.

6. Dispositif de réglage suivant la revendication 4 ou 5,

**caractérisé**
**en ce que** le dispositif (15) de commande fixe le premier facteur ($\gamma$) de pondération et le deuxième facteur ($\beta$) de pondération à des valeurs définies à l'avance.

7. Dispositif de réglage suivant la revendication 1,
**caractérisé**
**en ce que** le dispositif de commande, avant ou après l'envoi du signal (u) d'excitation à la mémoire (11) tampon arrière et au point (3) nodal arrière,

- supprime l'utilisation du signal (sv) de sortie de la mémoire (10) tampon avant, comme signal (K) de compensation,
- envoie à la mémoire (11) tampon arrière et au point (3) nodal arrière, comme signal (K) de compensation, au moins un autre signal (u') d'excitation,
- détecte le signal (e') de résultat ainsi provoqué, le signal (e') de résultat maintenant provoqué étant la différence ($\delta$x) de réglage maintenant provoqué, le signal (s2) somme intérieur maintenant provoqué, le signal (sf) de sortie maintenant provoqué du filtre (9) de fréquence ou le signal (sv) de sortie maintenant provoqué de la mémoire (10) tampon avant et
- sur la base d'une exploitation du signal (u) d'excitation et du signal (e) de résultat d'une part et de l'autre signal (u') d'excitation et du signal (e') de résultat ainsi provoqués d'autre part, décide s'il effectue la commande du au moins paramètre (P) du filtre (9) de fréquence et du deuxième retard (T2) de temps de propagation suivant la revendication 2 ou 3 d'une part ou la revendication 4, 5 ou 6 d'autre part.

8. Dispositif de réglage suivant l'une des revendications précédentes,
**caractérisé**

- **en ce que** le dispositif de réglage a un dispositif (16) de contrôle,
- **en ce que** le dispositif (16) de contrôle contrôle en fonctionnement normal du dispositif de réglage automatiquement la variation dans le temps du signal (K) de compensation et
- **en ce que** le dispositif (16) de contrôle supprime l'envoi du signal (sv) de sortie de la mémoire (10) tampon avant au point (3) nodal arrière et/ou règle le au moins un paramètre (P) du filtre (9) de fréquence et/ou le deuxième retard (T2) de temps de propagation à des valeurs autres, dès que le contrôle de la variation dans le temps du signal (K) de compensation indique une instabilité du circuit de compensation.

9. Dispositif de réglage suivant l'une des revendications précédentes,
**caractérisé**
**en ce qu'**il est constitué, sous la forme d'un dispositif de réglage programmable par logiciel et est programmé par un module (18) logiciel, de manière à être constitué sur la base de la programmation par le module (18) logiciel suivant l'une des revendications précédentes.

10. Dispositif de réglage suivant l'une des revendications précédentes,
**caractérisé**
**en ce qu'**il est utilisé pour commander un axe d'une machine à imprimer.

11. Module logiciel, qui comprend des codes de machine (19), dont l'élaboration, par un dispositif de réglage programmable par logiciel, fait que le dispositif de réglage est constitué suivant l'une des revendications 1 à 9.

12. Module logiciel suivant la revendication 11,
**caractérisé**
**en ce qu'**il est mémorisé sous une forme déchiffrable par ordinateur sur un support (20) de données.

# FIG 1

# FIG 2

## FIG 3

## FIG 4

# FIG 5

```
┌─────────────────┐
│      G(s)       │──── S11
└─────────────────┘
         │
         ▼  ◄─────────────────────────────────┐
┌─────────────────┐                           │
│  Vi = (P, T2, …) │──── S12                  │
└─────────────────┘                           │
         │                                     │
         ▼                                     │
┌─────────────────┐                           │
│     Ai(f)       │──── S13                   │
└─────────────────┘                           │
         │                                     │
         ▼                                     │
┌─────────────────┐                           │
│      Aim        │──── S14                   │
└─────────────────┘                           │
         │                                     │
         ▼                                     │
      ◇─────────◇                             │
    ◇             ◇──── S15                   │
   ◇  Aim < AMAX?  ◇────── −                  │
    ◇             ◇           │               │
      ◇─────────◇             │               │
         │ +                  │               │
         ▼                    ▼               │
┌─────────────┐      ┌─────────────┐          │
│   Vi  ✓     │─S17  │  ⋈  Vi  ⋈   │─── S16   │
└─────────────┘      └─────────────┘          │
         │ ◄──────────────┘                   │
         ▼                                     │
      ◇─────────◇                             │
    ◇             ◇──── S18                   │
   ◇      ?        ◇────── − ─────────────────┘
    ◇             ◇
      ◇─────────◇
         │ +
         ▼
┌─────────────────┐
│  Vi:fG ─► max   │──── S19
└─────────────────┘
         │
         ▼
┌─────────────────┐
│   P = P(Vi)     │──── S20
│   T2 = T2(Vi)   │
└─────────────────┘
```

# FIG 6

# FIG 7

$fT = fT(u,e)$ — S21

$P = P(fT)$
$fG = \alpha1 \cdot fT$ — S22

$fH = \alpha2 \cdot fT$
$T2 = TL(fH)$ — S23

$\gamma = \beta = 1$ — S24

## FIG 8

FIG 9

FIG 10

FIG 11

**IN DER BESCHREIBUNG AUFGEFÜHRTE DOKUMENTE**

**In der Beschreibung aufgeführte Patentdokumente**

- EP 2988181 A1